(19) Europäisches Patentamt
European Patent Office
Office européen des brevets

(11) **EP 2 063 634 A1**

(12) **EUROPEAN PATENT APPLICATION**

(43) Date of publication:
**27.05.2009 Bulletin 2009/22**

(51) Int Cl.:
*H04N 5/455* (2006.01) *H03J 1/00* (2006.01)
*H03L 7/099* (2006.01)

(21) Application number: **07121531.3**

(22) Date of filing: **26.11.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(71) Applicant: **Alcor Micro, Corp.**
**Nei Hu, Taipei (TW)**

(72) Inventors:
• **Chang, Chi-Tung**
**Taipei (TW)**
• **Lai, Chih-Hao**
**Taipei (TW)**
• **Hwang, Chieh-Tsao**
**Taipei (TW)**

(74) Representative: **Viering, Jentschura & Partner**
**Postfach 22 14 43**
**80504 München (DE)**

(54) **Frequency synthesizer applied to a digital television tuner**

(57) A frequency synthesizer applied to a digital television tuner includes: a voltage controlled oscillator (VCO), a phase locked loop (PLL), a frequency divider unit, and a multiplexer. The maximum oscillated frequency of the VCO is twice its minimum frequency. The PLL controls and locks the VCO output frequency by a frequency control signal. The frequency divider unit includes a plurality of first dividers which form a cascade connection. The frequency divider unit receives the VCO output frequency, and subsequently divides the output frequency one by one. The multiplexer receives the dividing signals, and then chooses one of the dividing signals by a frequency selection signal, and generates a local oscillation signal. Hence, the present invention can implement the frequency synthesizer by simple architecture and cover the frequency ranges of Digital Video Broadcasting standard.

FIG. 2

EP 2 063 634 A1

**Description**

BACKGROUND OF THE INVENTION

1. Field of the invention

The present invention relates to a frequency synthesizer, and more particularly to a frequency synthesizer applied to a digital television tuner.

2. Description of Related Art

As communication and compression technologies advance rapidly, digital television broadcasting has gradually replaced analog television broadcasting. The change to digital television broadcasting drives fast development of its related industries, particularly in the areas of set-top-box (STB) and mobile digital televisions devices. To cope with specifications for different standard modulated signals, a tuner circuit plays an important role in the digital television receiving system.

Generally speaking, since a digital television signal adopts carrier frequency range including VHF III (170~230MHz), UHF (470~862MHz), and even L-band (1400~1800MHz) that is specified used in Northern America. The tuner requires a frequency synthesizer capable of providing an equivalent frequency to perform a frequency tuning for signals having a frequency within the range of 170~1800MHz, and provide a local oscillation (LO) frequency for receiving and processing the signals thoroughly.

As to the specifications of frequency synthesizers for present existing digital television tuners, the requirements of phase noises are very strict, and thus an inductor-capacitor voltage controlled oscillator (LC VCO) is generally used in the design of VCO. However, a major bottleneck of the technology is that the digital television tuner requires a broadband oscillation frequency range with a ratio of more than ten between the lowest frequency 170MHz and the highest frequency 1800MHz. If the traditional design of LC VCO is used, the VCO gain (Kv) will varies a lot between the highest and lowest oscillation frequencies.

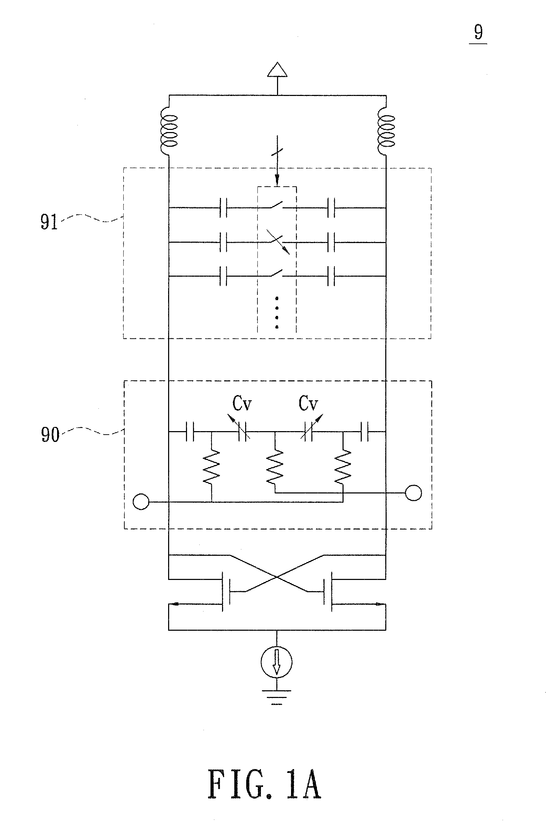

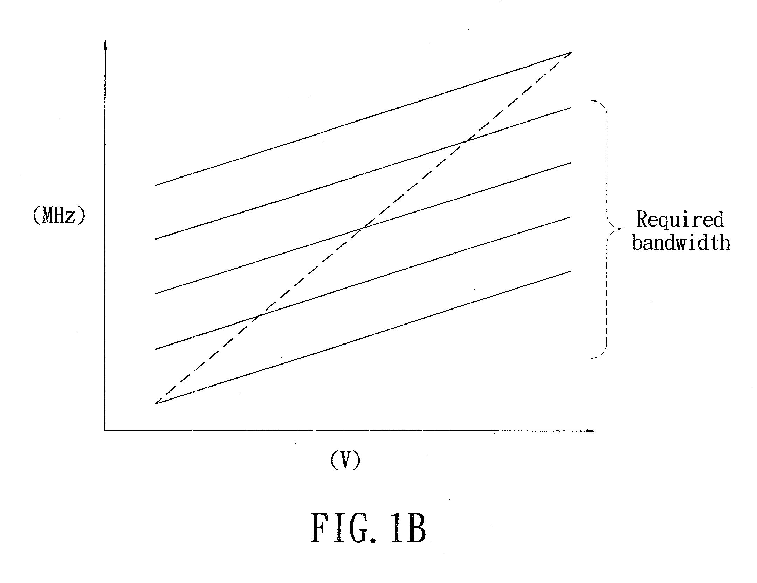

Referring to Figs. 1A and 1B for an LC VCO, oscillation frequency of the LC VCO 9 is controlled by a change of controlled voltage to a varactor module 90. To avoid a too-large VCO gain as indicated by the dotted line of the curve in Fig. 1B, the design limits the maximum value of VCO gain according to the system requirements. In addition, a design of installing a plurality of sets of capacitors in a switching capacitor module 91 is provided for switching and producing a plurality of smaller VCO gain curves as indicated by the solid lines in Fig.1B to cover the required bandwidth of the digital television tuner.

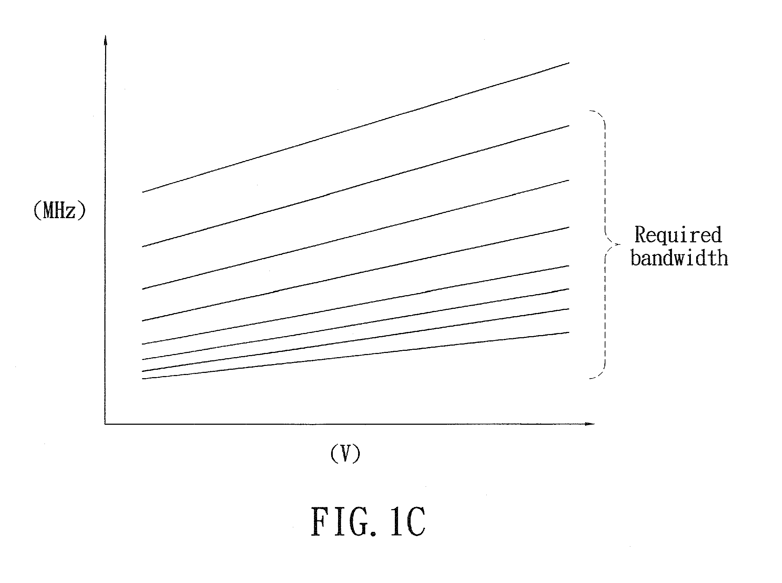

However, the curve in solid lines of Fig. 1B is produced with a narrow frequency range to maintain substantially the same VCO gain. Referring to Fig. 1C for the relation of an oscillation frequency and a controlled voltage of a broadband VCO by traditional architecture (such as a digital television tuner) of a traditional VCO that simply uses a switching capacitor module for the adjustment. The variation of VCO gain between high and low frequencies is very large. In the figure, the higher the oscillation frequency, the larger is the VCO gain (or the slope of the curve), and vise versa. Such broadband LO frequency range not only increases the level of difficulty of designing a VCO by a traditional LC oscillator, but also affects the stability of the phase locked loop.

At present, it is impossible to simply design one VCO to cover such a wide frequency range for a digital television tuner specification. Someone designed a frequency synthesizer using three sets of independent phase locked loops and VCOs to generate low, middle, and high-bandwidth LO signals (approximately 420MHz~580MHz, 550MHz~750 MHz and 700-1000MHz) respectively as shown in Fig. ID. It covers all UHF bandwidths in the digital television specification to cope with the frequency variation between high and low frequencies. Similarly, most of the frequency synthesizers applied to a digital television tuner adopt 2~4 VCOs to cover such a broad frequency range.

In addition, the closed loop gain must be controlled within a specific range of the phase locked loop in the frequency synthesizer to maintain the stability of the phase locked loop. Due to the frequency synthesizer requires a coverage of approximately 10 times of the frequency range (1800 MHz /170MHz) and the change of the VCO gain becomes too large which varies a lot the closed loop gain of the PLL and cause unstable. Therefore, it is necessary to constantly adjust each parameter in the phase locked loop (such as a phase frequency detector gain, divider number or low-pass filter value) to maintain the stability of the phase locked loop. In addition, the frequency divider of the phase locked loop requires 10 times of the frequency of operating range to cover the frequency range of 170~1800MHz. For a wider operating frequency range of the frequency divider design, it is necessary to have a larger consumption of current.

Obviously, finding a way of using a simpler hardware architecture and a less power-consuming method to design a stable frequency synthesizer capable of covering a broader frequency range requires further improvements.

SUMMARY OF THE INVENTION

The primary objective of the present invention is to provide a VCO capable of covering a frequency range with $f_{max}/f_{min} \geq 2$, and further add a series of frequency divisions, such that a simpler and easier hardware architecture and a power-saving design to achieve a frequency range of the frequency synthesizer capable of covering the required frequency of a digital television signal.

The present invention provides a frequency synthesizer applied to a digital television tuner, and comprises: a phase locked loop, a VCO covering a frequency range with $f_{max}/f_{min} \geq 2$, a frequency divider unit and a multiplexer. The phase locked loop is provided for receiving a frequency signal, and outputting a frequency control signal to determine the output frequency of the VCO with respect to a reference clock signal. The frequency divider unit is electrically coupled to the VCO, and comprises a plurality of first frequency dividers to form a cascade connection. After the first frequency dividers receive the VCO output frequencies, the frequencies are divided one by one to generate a plurality of frequency dividing signals. The multiplexer receives the frequency dividing signals and selects outputting one of the frequency dividing signals according to a frequency selection signal to form a local oscillation signal. With the design of the present invention, the frequency synthesizer can achieve the effect of covering a broader frequency range.

To make it easier for our examiner to understand the expected objectives, technical measures and effects of the present invention, we use preferred embodiments together with the attached drawings for the detailed description of the invention. However, it should be pointed out that the attached drawings are provided for reference and description only, but not for limiting the present invention.

BRIEF DESCRIPTION OF THE DRAWINGS

Fig. 1A is a schematic circuit diagram of a prior art VCO;
Fig. 1B shows the relation of an oscillation frequency and a controlled voltage of a traditional VCO;
Fig. 1C shows the relation of an oscillation frequency and a controlled voltage of a broadband VCO by traditional architecture;
Fig. 1D is a curve of frequencies covered by a prior art plurality frequency synthesizer;
Fig. 2 is a block diagram of a frequency synthesizer in accordance with the first embodiment of the present invention;
Fig. 3 is a block diagram of a frequency synthesizer in accordance with the second embodiment of the present invention; and
Fig. 4 is schematic circuit block diagram of a VCO of the present invention.

DETAILED DESCRIPTION OF THE PREFERRED EMBODIMENTS

The present invention is described in details by preferred embodiments together with attached drawings as follows:

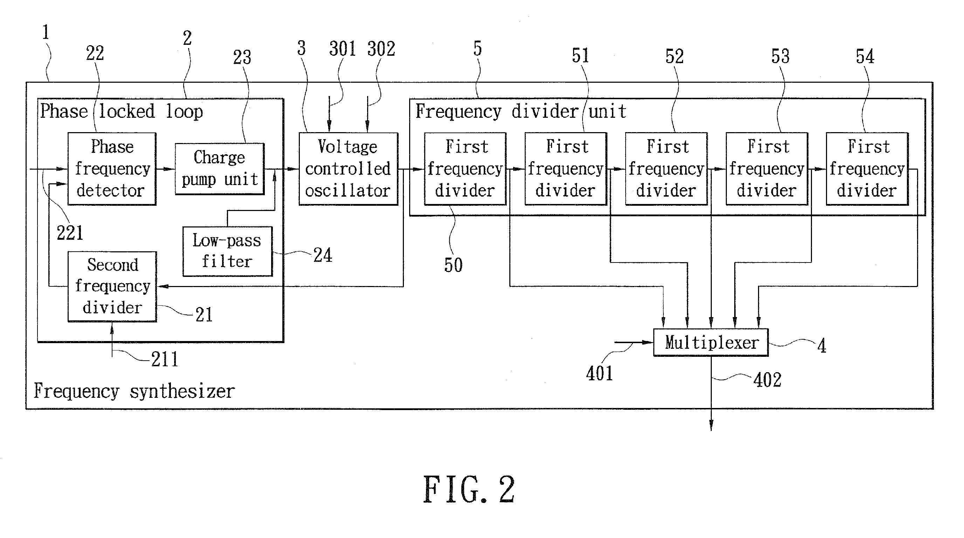

Referring to Fig. 2 for a block diagram of a frequency synthesizer in accordance with a first preferred embodiment of the present invention, the present invention is a frequency synthesizer 1 applied in a digital television tuner (not shown in the figure), comprising: a phase locked loop 2, a VCO 3, a multiplexer 4 and a frequency divider unit 5. The phase locked loop 2 further comprises a second frequency divider 21, a phase frequency detector 22, a charge pump unit 23 and a Low-pass filter 24. Further, the design of the VCO 3 covers a frequency range with $f_{max}/f_{min} \geq 2$. In other words, the maximum oscillation frequency equals to (or larger than) twice of the minimum oscillation frequency of the VCO 3. To cover different ranges of the digital television signals, the VCO 3 can be designed to cover a frequency range of 1800~3600MHz (3600/1800≥2).

The phase locked loop 2 uses a second frequency divider 21 to receive a frequency signal, and selects a divisor according to a channel selection signal 211 controlled by the digital television tuner, such that the second frequency divider 21 divides the frequency of the received frequency signal by the divisor then generates a feedback frequency signal. In a practical application, the second frequency divider 21 will have a different divisor for a different source of capturing the frequency signals.

After the phase frequency detector 22 has received the feedback frequency signal, the feedback frequency signal is compared with a reference clock signal 221, and the comparison result is used for outputting a charge/discharge digital signal. The charge pump unit 23 connected to the phase frequency detector 22 is used for converting the charge/discharge digital signal into an analog signal to control the VCO 3 to produce a VCO output frequency. In addition, the low-pass filter 24 is used for further filtering unstable high-frequency noises in the frequency control signal. Therefore, the phase locked loop 2 can output frequency control signals in a stable manner to control the VCO 3 to be locked at a desired VCO output frequency.

Since the phase locked loop 2 comes with a VCO 3 that covers a frequency range with $f_{max}/f_{min} \geq 2$, the range of the operating clock of the second frequency divider 21 is also designed to be twice as broad to receive the VCO output frequency produced by the VCO 3. In this embodiment, the frequency signal received by the second frequency divider 21 is a VCO output frequency produced directly by the VCO 3. The second frequency divider 21 can be an integer frequency divider or a fraction frequency divider, so that the whole phase locked loop 2 determines all integer frequencies or a fraction frequency in a frequency range produced by the VCO 3.

The frequency divider unit 5 is electrically coupled to the VCO 3, and the frequency divider unit 5 comprises a plurality of first frequency dividers 50~54 to sequentially form a cascade connection as shown in the figure, wherein the first frequency dividers 50~54 can be frequency dividers with a variable frequency division multiple or frequency dividers with a fixed frequency division multiple to meet the requirements of different applications and designs.

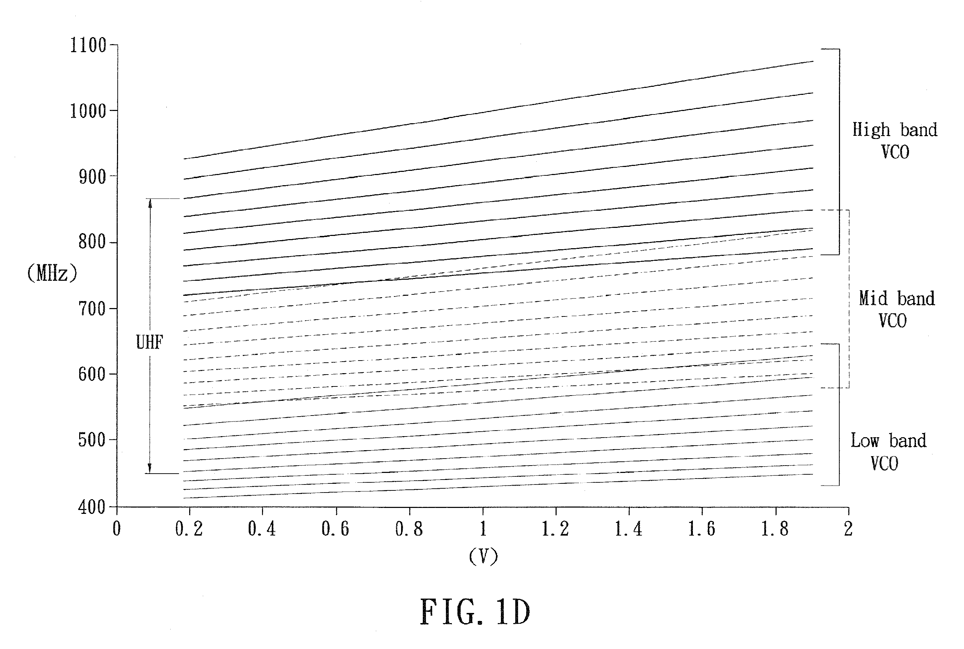

In addition, the architecture of the frequency synthesizer 1 adopts a plurality of first frequency dividers 50~54 to form a cascade connection, and thus the frequency divider unit 5 will form a plurality of levels of frequency bands by a frequency division according to the frequency range of the VCO 3. In Fig. 1 the design comes with five first frequency dividers 50-54, and the frequency division multiple of each first frequency divider 50~54 is fixed to be two. Assumed that the frequency range of the VCO 3 is 1800~3600MHz, the first frequency dividers 50~54 are cascaded to form frequency bands of 900~1800MHz, 450~900MHz, 225~450MHz, 122.5~225MHz and 61.25~122.5MHz respectively. In this embodiment, the frequency division multiple of the first frequency dividers 50~54 is designed to be two in order to cope with the frequency range of the VCO 3 that connects each sequentially formed frequency band through the first frequency dividers 50~54. As described above, the frequency division multiple of the first frequency divider 50~54 can be changed to a frequency divider with a variable frequency division multiple according to the requirement of the actual design.

In the operation of the frequency synthesizer 1, after the frequency divider unit 5 actually receives a VCO output frequency produced by the VCO 3, the VCO output frequency goes through a series of frequency divisions by the first frequency dividers 50~54 to generate a frequency dividing signal in each frequency band. The multiplexer 4 is provided for receiving all of the foregoing produced frequency dividing signals and switching a required frequency band of the frequency dividing signal according to a frequency selection signal 401 to form a local oscillation signal 402 for the use of a digital television tuner. The frequency selection signal 401 defines and chooses the frequency bands by a digital television tuner through a combination of a plurality of bits. For example, five first frequency dividers 50~54 are used to form five frequency bands, and thus a combination of at least three bits is required for fully defining each frequency band.

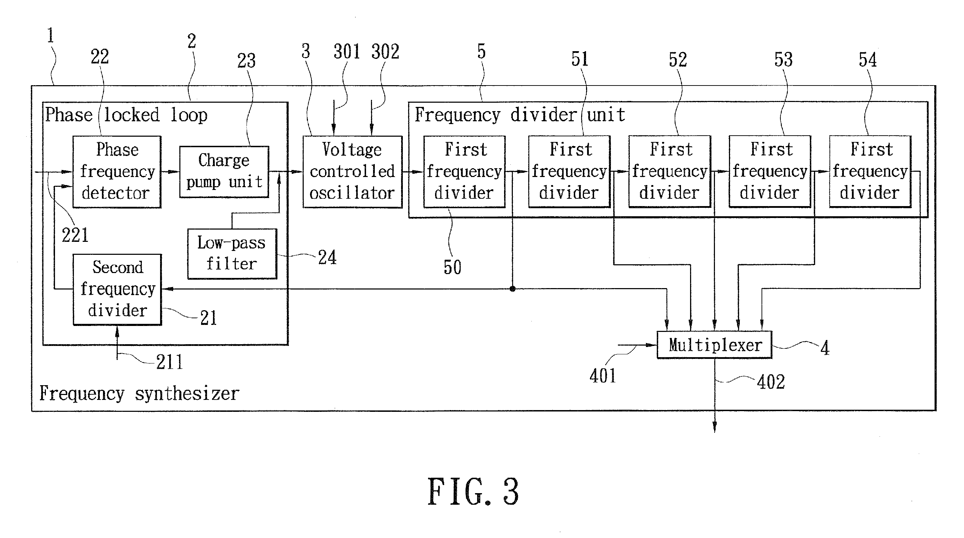

Referring to Fig. 3 for a block diagram of a frequency synthesizer in accordance with a second preferred embodiment of the present invention, the design of this embodiment is substantially the same as the first preferred embodiment, and the major difference resides on that a frequency signal received by the second frequency divider 21 of the phase locked loop 2 is one of the frequency dividing signals produced by the frequency divider unit 5. In addition, the divisors of the second frequency divider 21 has to be modified to meet the output frequency range of frequency divider unit 5. However, the different divisors formed by the second frequency divider 21 as described above can be designed and changed by a prior art, but it is not intended to limit the present invention.

From the foregoing embodiment, the frequency synthesizer 1 of the present invention can be achieved by simply using a VCO 3. The architecture and operation of the VCO 3 are disclosed further as follows.

Firstly, the frequency synthesizer 1 requires covering a broader frequency range (approximately equal to 10 times of the original frequency range), and also maintains a stable closed loop gain of the phase locked loop 2, and thus the VCO 3 must maintain the same frequency change (meaning that the slopes of the curves at different frequencies, or said VCO gain, are the same) by the variable VCO gain through the control of a VCO curve selection signal 301 and a VCO gain selection signal 302 to output VCO output frequencies of different frequencies, and further maintain a stable value of the closed loop gain of the phase locked loop 2.

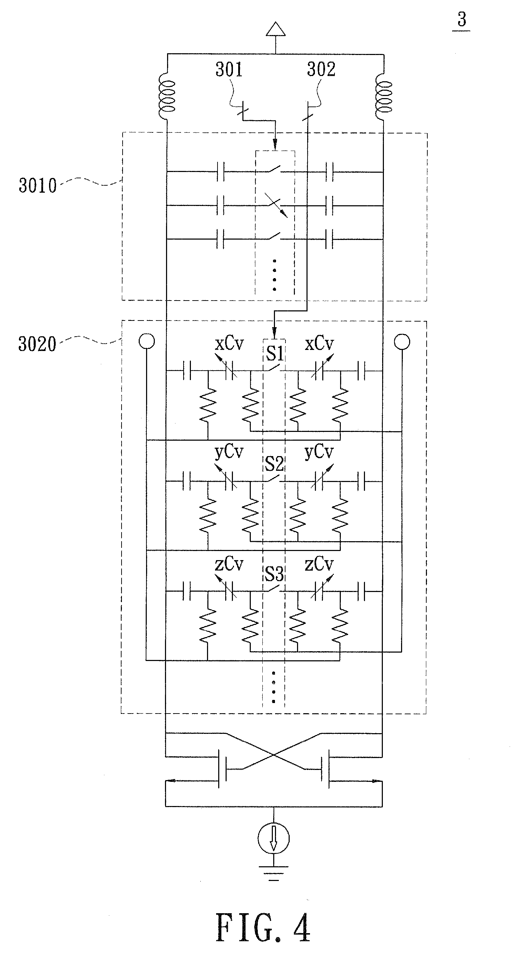

Referring to Fig. 4 for a schematic circuit block diagram of a VCO in accordance with the present invention, the internal circuit and control method of the VCO 3 are described further. The VCO 3 comprises a switching capacitor module 3010 and a switching varactor module 3020. The switching varactor module 3020 includes a plurality of switching varactors to form a parallel connection, while receiving the control of a VCO gain selection signal 302 to adjust the sum of voltage controlled capacitances formed by the switching varactors, and the switching capacitor module 3010 is connected in parallel with the switching varactor module, and the switching capacitor module 3010 also has a plurality of modules of switching capacitors to form a parallel connection and further adjust the sum of the switching capacitances formed by the sum of switching capacitors and switching varactors through the control of the VCO curve selection signal 301. In this embodiment, the foregoing switching capacitors are combined in a ratio of two times and connected in parallel in an equal ratio of 1, 2, 4 and 8.

On the other hand, if the switching varactor module 3020 only has a module of switching varactors, then the same capacitance change formed by the voltage control capacitance will have a very large difference of the frequency change at high and low frequencies. In other words, the lower the VCO output frequency, the smaller is the range of the frequency change (and the smaller is the VCO gain) by the same capacitance change. The higher the VCO output frequency, the larger is the frequency change (and the larger is the VCO gain). As a result, the stability of the phase locked loop 2 cannot be maintained due to VCO gain couldn't be keep the same oscillation frequency from high to low.

However, this embodiment designs a plurality of modules of switching varactors in the switching varactor module 3020 to adjust the switching varactors by a control of the VCO gain selection signal 302, such that the VCO output frequency in each frequency has the same frequency control range (or the same slope). The switching capacitance is adjusted to combine the required oscillation frequency for the VCO 3.

Referring to the following formulas of frequency, we can know how to maintain the same frequency change in each different oscillation frequency. Assumed that in the VCO 3, the inductance Lx is constant, and the change of

$$\Delta f_H = \frac{1}{2\pi\sqrt{Lx(Cx)}} - \frac{1}{2\pi\sqrt{Lx(Cx + \Delta C)}} = \frac{1}{2\pi\sqrt{LxCx}}(1 - \sqrt{\frac{Cx}{Cx + \Delta C}})$$

the voltage controlled capacitance is $\Delta C$, and the switching capacitances of the capacitors connected in parallel at high and low frequencies are Cx and 2Cx respectively. At high frequency, the frequency change of the VCO 3 is given below:

At low frequency, the frequency change of the VCO 3 is given below:

To maintain the same frequency change ($\Delta fH = \Delta fL$) produced by the VCO

$$\Delta f_L = \frac{1}{2\pi\sqrt{Lx(2Cx)}} - \frac{1}{2\pi\sqrt{Lx(2Cx + mCv)}} = \frac{1}{2\pi\sqrt{LxCx}}[\frac{1}{\sqrt{2}}(1 - \sqrt{\frac{2Cx}{2Cx + mCv}})]$$

3 at high and low frequencies, we simply need to adjust the sum of the voltage controlled capacitances to satisfy the following equation and find the value m therein by means of a VCO gain selection signal 302 to control the switching varactors in a switching varactor module 3020.

$$[\frac{1}{\sqrt{2}}(1 - \sqrt{\frac{2Cx}{2Cx + mCv}})] = (1 - \sqrt{\frac{Cx}{Cx + \Delta C}})$$

In the design of the switching varactors, the capacitors are not combined in a ratio of a fixed multiple, but a programmable conversion ration is used for the design. In other words, m=S1*xCv+S2*yCv+S3*zCv+..., where S1, S2, S3 are switching varactors with a value of 1 or 0, and used for selectively turning on or off the varactors xCv, yCv, zCv, and x, y, z are programmable conversion ratios to be operated with a switch S to calculate the value m.

Some real volumns are used for the illustration here. Assumed that the inductance of the VCO 3 is set to a constant InH, there will be a change of 100fF per an increase of one volt, if only a module of switching varactors is designed. For example, the VCO 3 controls the capacitance of the switching capacitors, originally connected in parallel to 1pF, and thus the outputted oscillation frequency approximately equals to 5030MHz. If the capacitance of the switching varactors varies with voltage, such that the capacitance of the capacitors of the entire VCO 3 is changed to 1.1pF, and the outputted oscillation frequency will become approximately 4800MHz. Therefore, the VCO 3 has a frequency change of approximately 230MHz in this frequency range. From the foregoing frequency formulas, it is known that the square roots of the capacitances are inversely proportional to each other. Therefore, the switching capacitance of the capacitors of the VCO 3 (originally connected in parallel) will be 2pF to facilitate producing a frequency (approximately 3560MHz) at a lower frequency range. If the capacitance of the switching varactors varies with voltage such that the capacitance of the capacitors of the entire VCO 3 (connected in parallel) is changed to 2.1pF, then the outputted oscillation frequency will be approximately 3473MHz. Now, the frequency change of the VCO 3 in this frequency range is approximately 87MHz. By the way, if the oscillator at 3560MHz needs to have a frequency change of 230MHz, the switching varactors should varies 284fF. Due to this characteristic, the high frequency change ($\Delta fH$) of the oscillator is much greater than the low frequency change ($\Delta fL$) in a wideband system. Therefore, the present invention designs a plurality of modules of switching varactors in the switching varactor module 3020 of the VCO 3 to adjust the sum of voltage controlled capacitances formed by the switching varactors according to the control of the VCO gain selection signal 302, so that the VCO 3 under every frequency has the same frequency control range (or same slope) within the oscillation frequency.

It is noteworthy to point out that the aforementioned VCO curve selection signal 301; the VCO gain selection signal 302, the channel selection signal 211 and the frequency selection signal 401 are controlled by the frequency synthesizer 1 according to the frequency requirement of the desired digital television signal received by the digital television tuner.

Different numeric values are used as examples for illustrating the results produced in actual operation of the present invention. Referring to Fig. 3 for an architecture in accordance with a preferred embodiment of the present invention, the frequency division multiple of the first frequency dividers 50~54 is two times, and the produced frequency bands are 900~1800MHz, 450~900MHz, 225~450MHz, 122.5~225MHz and 61.25~122.5MHz respectively. If the frequency of the required local oscillation signal 402 is 230MHz, the frequency selection signal 401 will switch the multiplexer 4 to a frequency band of 225~450MHz. Since the frequency band of 225~450MHz is a frequency band obtained by dividing the frequency to three levels by the VCO 3. Therefore, we can know that the VCO output frequency of the VCO 3 is 230MHz* 8=1840MHz. Now, the frequency signal received by the phase locked loop 2 is 1840MHz/2=920MHz, and the second frequency divider 21 fixes the divisor to 920 by using the channel selection signal 211, such that a feedback frequency signal generated by the second frequency divider 21 is compared with a reference clock signal 221 of 1MHz to generate a frequency control signal for determining the VCO output frequency outputted by the VCO 3, so as to lock the phase locked loop 2 at a frequency of 1840MHz.

In another example, if the frequency of the required local oscillation signal 402 is 1650MHz, the frequency selection signal 401 will switch the multiplexer 4 to a frequency band of 900~1800MHz. Since the frequency band of 900~180MHz is a frequency band obtained by dividing the frequency to one level by the VCO 3, we can know that the VCO output frequency of the VCO 3 is 1650MHz*2=3300MHz. Now, the frequency signal received by the phase locked loop 2 is 3300MHz/2=1650MHz. Therefore, the second frequency divider 21 fixes the divisor to 1650 by using the channel selection signal 211, such that a feedback frequency signal generated by the second frequency divider 21 is compared with a reference clock signal 221 of 1MHz to produce a controlled voltage of the VCO 3, so as to lock the phase locked loop 2 at a frequency of 3300MHz.

In summation of the description above, the present invention designs a VCO capable of covering a frequency range with $f_{max}/f_{min} \geq 2$, and designs a frequency operating range of the corresponding frequency divider in the phase locked loop to achieve a simpler hardware architecture and a power-saving method for covering a frequency range of the frequency synthesizer for the required frequencies of the digital television signal. In the meantime, several switching varactors are designed in the VCO for the control and adjustment. Regardless of high and low frequencies, a variable VCO gain can be used for maintaining the same frequency change (or same slope), so as to maintain a stable value for the closed loop gain of the phase locked loop.

Although the present invention has been described with reference to the preferred embodiments thereof, it will be understood that the invention is not limited to the details thereof. Various substitutions and modifications have been suggested in the foregoing description, and others will occur to those of ordinary skill in the art. Therefore, all such substitutions and modifications are intended to be embraced within the scope of the invention as defined in the appended claims.

**Claims**

1. A frequency synthesizer, applied to a digital television tuner, comprising:

   a voltage controlled oscillator (VCO), capable of covering a frequency range with $f_{max}/f_{min} \geq 2$, for generating a VCO output frequency;
   a phase locked loop, for outputting a frequency control signal according to a reference signal to determine the VCO output frequency;
   a frequency divider unit, electrically coupled to the VCO, comprising a plurality of first frequency dividers to form a cascade connection, for receiving the VCO output frequency, and the first frequency dividers being used for a frequency division to generate a plurality of frequency dividing signals; and
   a multiplexer, for receiving the frequency dividing signals, and choosing one of the frequency dividing signals as a local oscillation signal according to a frequency selection signal.

2. The frequency synthesizer as recited in claim 1, wherein the frequency range has a maximum frequency generated by the VCO equal to twice the minimum frequency.

3. The frequency synthesizer as recited in claim 2, wherein the frequency range is a frequency range from 1800MHz to 3600MHz.

4. The frequency synthesizer as recited in claim 1, wherein the VCO further receives a control of a VCO gain selection signal and a VCO curve selection signal to provide the same frequency change for the outputted VCO output frequency.

5. The frequency synthesizer as recited in claim 4, wherein the VCO further comprises:

a switching varactor module, having a plurality of switching varactors to form a parallel connection, for receiving a control of the VCO gain selection signal to adjust the sum of voltage controlled capacitances formed by the switching varactors, so that the VCO at a different frequency with the similar frequency control range; and
a switching capacitor module, connected in parallel with the switching varactor module, and including a plurality of switching capacitors to form a parallel connection, and receive a control of the VCO curve selection signal to adjust the sum of switching capacitances formed by the sum of switching capacitors and switching varactors, such that the output frequency generated by the VCO has the same tuning range.

6. The frequency synthesizer as recited in claim 5, wherein the switching capacitors and the switching varactors are of a programmable conversion ratio.

7. The frequency synthesizer as recited in claim 1, wherein the phase locked loop further comprises:

a second frequency divider, for receiving the frequency signal to fix a divisor according to a channel selection signal, and divide the frequency signal by the divisor to generate a feedback frequency signal;
a phase frequency detector, for comparing the feedback frequency signal with a reference clock signal to output a charge/discharge digital signal;
a charge pump unit, for converting the charge/discharge digital signal into an analog signal to form the frequency control signal; and
a low-pass filter, for filtering high-frequency noise from the frequency control signal.

8. The frequency synthesizer as recited in claim 7, wherein the second frequency divider has an operating clock range with max/min=2.

9. The frequency synthesizer as recited in claim 7, wherein the second frequency divider is an integer frequency divider or a fraction frequency divider, such that the phase locked loop can cause the VCO to generate an integer frequency or a corresponding fraction frequency.

10. The frequency synthesizer as recited in claim 1, wherein the first frequency dividers in the frequency divider unit are frequency dividers with variable frequency division or frequency dividers with fixed frequency division.

9

FIG. 1A

FIG. 1B

(MHz)

Required
bandwidth

(V)

# FIG. 1C

FIG. 1D

EP 2 063 634 A1

FIG. 2

FIG. 3

Frequency synthesizer

Phase locked loop

Phase frequency detector

Charge pump unit

Low-pass filter

Voltage controlled oscillator

Second frequency divider

Frequency divider unit

First frequency divider

Multiplexer

FIG. 4

**European Patent Office**

**EUROPEAN SEARCH REPORT**

Application Number

EP 07 12 1531

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | ANALOG DEVICES: "Integrated Synthesizer and VCO ADF 4360-7"[Online] 2004, XP002479684 Retrieved from the Internet: URL:http://www.analog.com/UploadedFiles/Data_Sheets/ADF4360-7.pdf> [retrieved on 2008-05-07] | 1,4,7-10 | INV. H04N5/455 H03J1/00 H03L7/099 |
| A | * page 1 * * page 4 * * page 10 - page 12 * * page 20 - page 22 * * figures 1,20,23 * | 2,3,5,6 | |
| Y | US 4 504 800 A (PLOUVIEZ ERIC [FR]) 12 March 1985 (1985-03-12) * abstract * * column 1, line 5 - line 10 * | 1-6 | |
| A | * column 1, line 31 - line 38 * * column 2, line 35 - line 68 * * column 3, line 29 - line 40 * * column 4, line 5 - line 44 * * figures 1,2 * | 7-10 | |
| Y | US 6 091 304 A (HARRER JAMES RICHARD [US]) 18 July 2000 (2000-07-18) * abstract * * column 1, line 62 - column 2, line 61 * | 1-6 | TECHNICAL FIELDS SEARCHED (IPC) H04N H03J H03L |
| A | * column 3, line 29 - column 6, line 46 * * column 9, line 51 - line 64 * * figures 1-8 * | 7-10 | |

-/--

The present search report has been drawn up for all claims

| Place of search | Date of completion of the search | Examiner |
|---|---|---|
| Munich | 9 May 2008 | Schreib, Franz |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | European Patent Office | EUROPEAN SEARCH REPORT | Application Number<br>EP 07 12 1531 |
|---|---|---|---|

## DOCUMENTS CONSIDERED TO BE RELEVANT

| Category | Citation of document with indication, where appropriate,<br>of relevant passages | Relevant<br>to claim | CLASSIFICATION OF THE<br>APPLICATION (IPC) |
|---|---|---|---|
| A | TEXAS INSTRUMENTS: "DATA SHEET SN74S163<br>SYNCHRONOUS 4-BIT Counters"[Online]<br>March 1988 (1988-03), XP002479746<br>Retrieved from the Internet:<br>URL:http://focus.ti.com/lit/ds/symlink/sn7<br>41s161a.pdf> [retrieved on 2008-05-08]<br>* page 1 *<br>* page 7 *<br>* page 11 *<br>----- | 1-10 | |
| A | US 2007/132515 A1 (LEE JA Y [KR] ET AL)<br>14 June 2007 (2007-06-14)<br>* abstract *<br>* paragraph [0002] *<br>* paragraph [0007] *<br>* paragraph [0020] *<br>* paragraph [0023] - paragraph [0033] *<br>* paragraph [0035] - paragraph [0036] *<br>* paragraph [0046] - paragraph [0049] *<br>* figures 1-8 *<br>----- | 1-10 | |
| A | US 2005/212604 A1 (CYR RUSSELL J [US] ET<br>AL) 29 September 2005 (2005-09-29)<br>* abstract *<br>* paragraph [0001] - paragraph [0024] *<br>* paragraph [0071] - paragraph [0077] *<br>* paragraph [0081] *<br>* paragraph [0083] - paragraph [0085] *<br>* paragraph [0093] - paragraph [0094] *<br>* paragraph [0111] - paragraph [0112] *<br>* paragraph [0120] - paragraph [0123] *<br>* figures 2,5-7,15,21,22 *<br>----- | | TECHNICAL FIELDS<br>SEARCHED (IPC) |

-/--

The present search report has been drawn up for all claims

| Place of search | Date of completion of the search | Examiner |
|---|---|---|
| Munich | 9 May 2008 | Schreib, Franz |

**European Patent Office**

**EUROPEAN SEARCH REPORT**

Application Number

EP 07 12 1531

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 3 980 951 A (BREEZE ERIC ET AL) 14 September 1976 (1976-09-14) * abstract * * column 1, line 6 - column 2, line 57 * * column 3, line 9 - line 50 * * table I * * figures 1-4 * ----- | | |

TECHNICAL FIELDS SEARCHED (IPC)

The present search report has been drawn up for all claims

| Place of search | Date of completion of the search | Examiner |
|---|---|---|
| Munich | 9 May 2008 | Schreib, Franz |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

..................................................................................

& : member of the same patent family, corresponding document

EPO FORM 1503 03.82 (P04C01)

**ANNEX TO THE EUROPEAN SEARCH REPORT
ON EUROPEAN PATENT APPLICATION NO.**                EP 07 12 1531

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2008

| Patent document cited in search report | | Publication date | Patent family member(s) | | Publication date |
|---|---|---|---|---|---|
| US 4504800 | A | 12-03-1985 | DE 3261949 D1 | | 28-02-1985 |
| | | | EP 0072271 A1 | | 16-02-1983 |
| | | | FR 2510287 A1 | | 28-01-1983 |
| | | | JP 58025724 A | | 16-02-1983 |
| US 6091304 | A | 18-07-2000 | KR 20000022625 A | | 25-04-2000 |
| US 2007132515 | A1 | 14-06-2007 | NONE | | |
| US 2005212604 | A1 | 29-09-2005 | NONE | | |
| US 3980951 | A | 14-09-1976 | NONE | | |

EPO FORM P0459

For more details about this annex : see Official Journal of the European Patent Office, No. 12/82